# EUROPEAN PATENT APPLICATION

(11) **EP 4 187 601 A1**
(43) Date of publication of application: **31.05.2023**
(21) Application number: 21211007.6
(22) Date of filing: 29.11.2021
(51) Int. Cl.: H01L 27/02, H01L 29/87

(54) **A SEMICONDUCTOR DEVICE AND A METHOD OF MANUFACTURE**

(71) Applicant: Nexperia B.V., 6534 AB Nijmegen (NL)
(72) Inventor: Holland, Steffen, 22529 Hamburg (DE); Ritter, Hans-Martin, 22529 Hamburg (DE)
(74) Representative: Pjanovic, Ilija

(57) **Abstract**

This disclosure relates to a semiconductor device comprising at least three regions, a first region, a second region, and a third region. The first region comprises a first layer and a second layer, wherein first layer and the second layer are positioned laterally along the first region, wherein the first layer and the second layer have opposite polarity. The second region comprises a third layer and a fourth layer, wherein third layer and the fourth layer are positioned laterally along the second region, wherein the third layer and the fourth layer have opposite polarity. The third region comprises a fifth layer and a sixth layer, wherein fifth layer and the sixth layer are positioned laterally along the third region, wherein the fifth layer and the sixth layer have opposite polarity. The first layer is positioned substantially across the third layer, the third layer is positioned substantially across the fifth layer, the second layer is positioned substantially across the fourth layer and the fourth layer is positioned substantially across the sixth layer.

## Description

### FIELD

The present invention relates to a method of forming a semiconductor device. The invention also relates to a method of manufacturing a semiconductor device.

### BACKGROUND

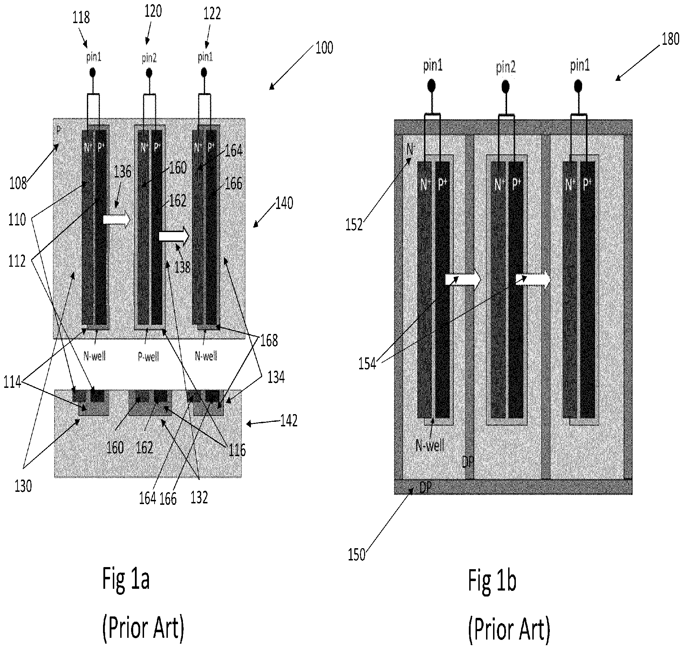

Known semiconductor devices are shown in Figures 1a and 1b.

A semiconductor device 100 shown in Figure 1a is shown from a top point of view, reference sign 140, and from a side point of view, reference sign 142. The semiconductor device comprises three regions, a first region 130, a second region 132, and a third region 134. These three regions 130, 132 and 134 are positioned horizontally next to each other, as shown in Figure 1a.

The semiconductor device comprises a P- area 108 wherein these three regions 130, 132 and 134 are positioned.

The first region 130 comprises a first N+ layer 110, a first P+ layer 112 and a first N-well 114 around the first P+ layer 112 and partially around the first N+ layer 110. The first N+ layer 110 and the first P+ layer 112 are of the same length and positioned parallel to each other.

The second region 132 comprises a second N+ layer 160, a second P+ layer 162 and a second P-well 116 around the second N+ layer 160 and partially around second P+ layer 162. The second N+ layer 160 and the second P+ layer 162 are of the same length and positioned parallel to each other.

The third region 134 comprises a third N+ layer 164, a third P+ layer 166 and a third N-well 168 around the third P+ layer 166 and partially around the third N+ layer 164. The third N+ layer 164 and the third P+ layer 166 are of the same length and positioned parallel to each other.

The semiconductor device further comprises three pins, a first pin 118 connected to the first region 130, a second pin 120 connected to the second region 132 and a third pin 122 connected to the third region 134.

Such positioning of N+ and P+ layers in the three regions shown in Figure 1a, secures that a current is flowing only from a P+ layer to a nearest N+ layer. i.e. from left to right in Figure 1a, as indicated with a first arrow 136. In the other direction there is a forward biased diode and the current flows in the same direction, but at a different location, as indicated with the second arrow 138.

Such a semiconductor device, known as a silicon controlled rectifier (SCR), is one-sided. The current can flow either in the direction indicated by the first arrow 136, or in the direction indicated by the second arrow 138. The current will always flow on one side of a region, not on both sides.

Another semiconductor device 180, also known in the art, is shown in Figure 1b. It is a variation of the semiconductor device 100 shown in Figure 1a. The differences in respect to the semiconductor device 100 shown in Figure 1a, are that the semiconductor device 180 shown in Figure 1b comprises a N- are 152, where the three regions are positioned. Furthermore, first and third region comprise a nwell instead of a pwell. the semiconductor device 180 shown in Figure 1b comprises a doping polarity isolation 150 around the three regions.

The semiconductor device 180 is also one-sided. The current flow in one direction is indicated by an arrow 154.

### SUMMARY

Various example embodiments are directed to the disadvantage as described above and/or others which may become apparent from the following disclosure.

According to an embodiment of the invention a semiconductor device comprises:
- at least three regions, a first region, a second region, and a third region,
- wherein the first region comprises a first layer and a second layer, wherein first layer and the second layer are positioned laterally along the first region, wherein the first layer and the second layer have opposite polarity,
- wherein the second region comprises a third layer and a fourth layer, wherein third layer and the fourth layer are positioned laterally along the second region, wherein the third layer and the fourth layer have opposite polarity,
- wherein the third region comprises a fifth layer and a sixth layer, wherein fifth layer and the sixth layer are positioned laterally along the third region, wherein the fifth layer and the sixth layer have opposite polarity.

The first layer can be positioned substantially across the third layer, the third layer can be positioned substantially across the fifth layer, the second layer can be positioned substantially across the fourth layer and the fourth layer can be positioned substantially across the sixth layer.

The invention is not limited to three regions. The number of regions can be four, five, six, seven, eight, or any other number.

The current flows directly from the anode to the cathode. Under ESD conditions this can cause current crowding at the edge of contacts or doping regions. For a two regions device the current has only one path (for instance from left to right, if the anode is at the left side and the cathode on the right side). A third region places an additional cathode on the left side of the anode. Now the current can flow from the anode to the right and to the left side to the cathode. This reduces the current density per area and thus increases the ESD robustness. As the anode area stays the same which determines the device capacitance the ratio of ESD robustness/capacitance can be improved by a third region.

The first layer, the fourth layer and the fifth layer can be of a first type. The second layer, the third layer and the sixth layer can be of a second type, opposite to the first type.

The current flows directly from the p part of the first region to the n part of the second region. The shorter this path the lower the resistance will be.

In ESD applications a low resistive device is of advantage. If a p part of the first region is placed opposite to another p part of the second region this causes the current to flow diagonally to the next adjacent n part of the second region because it is placed a bit lower. This increases the resistance of the device and thus causes a higher clamping voltage. In addition, if the p part is placed above the n part, it could happen that the current is concentrating at the lower end of the p part of the first region and the upper end of the n part of the second region which increases locally the current density which results in a lower ESD robustness.

The first type can be a N type, and the second type can be accordingly a P type. Or, the first type can be a P type, and the second type can be accordingly a N type.

The first region and the third region can be connected to a first pin, and the second region can be connected to a second pin.

According to an embodiment of the invention the first region can comprise a first well, wherein the polarity of the first well is opposite of the polarity of the first layer, and wherein the first well is positioned around the first layer. The second region can comprise a second well, wherein the polarity of the second well is opposite of the polarity of the third layer, and wherein the second well is positioned around the third layer. The third region can comprise a third well, wherein the polarity of the third well is opposite of the polarity of the fifth layer, wherein the third well is positioned around the third layer.

According to an embodiment of the invention the length of the first layer, the length of the second layer, the length of the third layer, the length of the fourth layer, the length of the fifth layer and the length of the sixth layer can be about the same size.

The first region can comprise of different number of layers, e.g. first eight layers, which first eight layers are of the first type and the second type alternatively. Accordingly the second region can also comprise of second eight layers, which second eight layers are of the second type and the first type alternatively. Finally the third region can comprise of third eight layers, which third eight layers are of the first type and the second type alternatively.

According to an embodiment of the invention the semiconductor device further comprises a doping polarity isolation directly under and around the regions, wherein the doping of the doping polarity isolation is lower than the doping of the wells.

According to an embodiment of the invention the semiconductor device comprises a substrate positioned directly under the doping polarity isolation, wherein the doping of the doping polarity isolation is lower than the doping of the substrate.

According to an embodiment of the invention the semiconductor device comprise a buried layer positioned between the doping polarity isolation and the substrate.

According to an embodiment of the invention the semiconductor device comprises deep wells between all the regions.

As already explained the invention is not limited to three regions. In exemplary embodiment of the present invention a semiconductor device further comprises a fourth region. The fourth region comprises a seventh layer and an eight layer, wherein seventh layer and the eighth layer are positioned laterally along the fourth region, wherein the seventh layer and the eighth layer have opposite polarity. The fifth layer is positioned substantially across the seventh layer, and the sixth layer is positioned substantially across the eighth layer. In this case the first region and the third region are connected to a first pin, and wherein the second region and the fourth region are connected to a second pin.

The present invention also relates to a semiconductor device that comprises at least two regions, a first region and a second region. The first region comprises a first layer of a first type, and a second layer of a second type, wherein the second type is opposite to the first type. The first layer and the second layer are positioned laterally along the first region. The second region comprises a third layer of the second type, and a fourth layer of the first type, wherein third layer and the fourth layer are positioned laterally along the second region. The first layer is positioned substantially across the third layer, and the second layer is positioned substantially across the fourth layer.

The present invention also relates to a method of producing a semiconductor device as described in the previous embodiments of the present invention.

The above described embodiments of the present invention secure that the junction capacitance of the semiconductor device is reduced by at least 15-20% while the same ESD robustness of the semiconductor device is maintained.

Moreover, the layout of the semiconductor service becomes more symmetric and therefore the triggering of adjacent fingers/regions/layers of the semiconductor device is not dependent on the position of the first triggered finger/region/layer.

Such a laterally segmented layout of an SCR, as described in the above embodiments of the present invention, allows to reduce the capacitance of the ESD protection semiconductor device. In addition, it allows that the current spreading between the SCR fingers occurs more homogeneously.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figures 1a and 1b show known semiconductor devices;
Figure 2 illustrates a semiconductor device according to an embodiment of the invention;
Figure 3 illustrates a semiconductor device according to an embodiment of the invention;
Figures 4a and 4b illustrate a semiconductor device according to an embodiment of the invention;
Figures 5a and 5b illustrate a semiconductor device according to an embodiment of the invention;
Figures 6a and 6b illustrate a semiconductor device according to an embodiment of the invention;
Figure 7 illustrates a semiconductor device according to an embodiment of the invention;
Figure 8 illustrates a semiconductor device according to an embodiment of the invention;
Figure 9 illustrates a semiconductor device according to an embodiment of the invention;

### DETAILED DESCRIPTION

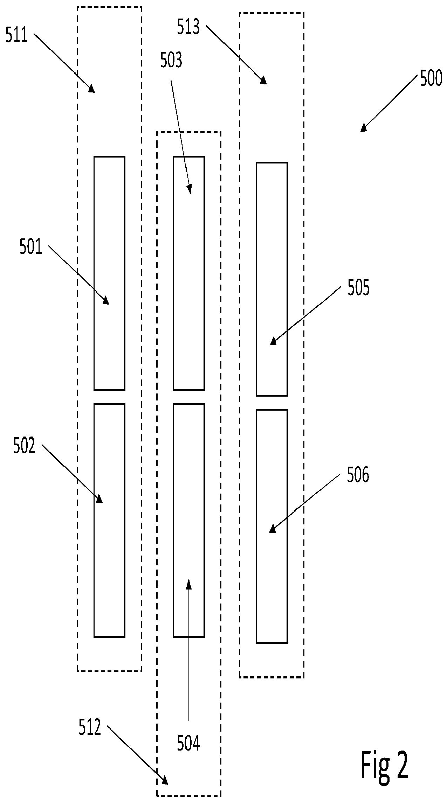

Figure 2 illustrates a semiconductor device 500 according to an embodiment of the present invention. The semiconductor device 500 comprises at least three regions, a first region 511, a second region 512, and a third region 513. The first region 511 comprises a first layer 501 and a second layer 502, wherein first layer 501 and the second layer 502 are positioned laterally along the first region 511, wherein the first layer 501 and the second layer 502 have opposite polarity. The second region 512 comprises a third layer 503 and a fourth layer 504, wherein third layer 503 and the fourth layer 504 are positioned laterally along the second region 512, wherein the third layer 503 and the fourth layer 504 have opposite polarity. The third region 513 comprises a fifth layer 505 and a sixth layer 506, wherein fifth layer 505 and the sixth layer 506 are positioned laterally along the third region 513, wherein the fifth layer 505 and the sixth layer 506 have opposite polarity.

The first layer 501 can be positioned substantially across the third layer 503, the third layer 503 can be positioned substantially across the fifth layer 505, the second layer 502 can be positioned substantially across the fourth layer 504 and the fourth layer 504 can be positioned substantially across the sixth layer 506. The invention also includes all other variations where these layers are not positioned across each other.

The invention is not limited to three regions. The number of regions can be four, five, six, seven, eight, or any other number.

The current flows directly from the anode to the cathode. Under ESD conditions this can cause current crowding at the edge of contacts or doping regions. For a two regions device the current has only one path (for instance from left to right, if the anode is at the left side and the cathode on the right side). A third region places an additional cathode on the left side of the anode. Now the current can flow from the anode to the right and to the left side to the cathode. This reduces the current density per area and thus increases the ESD robustness. As the anode area stays the same which determines the device capacitance the ratio of ESD robustness/capacitance can be improved by a third region.

The first layer 501, the fourth layer 504 and the fifth layer 505 can be of a first type. The second layer 502, the third layer 503 and the sixth layer 506 can be of a second type, opposite to the first type.

The current flows directly from the p part of the first region 511 to the n part of the second region 512. The shorter this path the lower the resistance will be.

In ESD applications a low resistive device is of advantage. If a p part of the first region is placed opposite to another p part of the second region this causes the current to flow diagonally to the next adjacent n part of the second region because it is placed a bit lower. This increases the resistance of the device and thus causes a higher clamping voltage. In addition, if the p part is placed above the n part, it could happen that the current is concentrating at the lower end of the p part of the first region and the upper end of the n part of the second region which increases locally the current density which results in a lower ESD robustness.

The first type can be a N type, and the second type can be accordingly a P type. Or, the first type can be a P type, and the second type can be accordingly a N type.

The first region 511 and the third region 513 can be connected to a first pin, and the second region can be connected to a second pin.

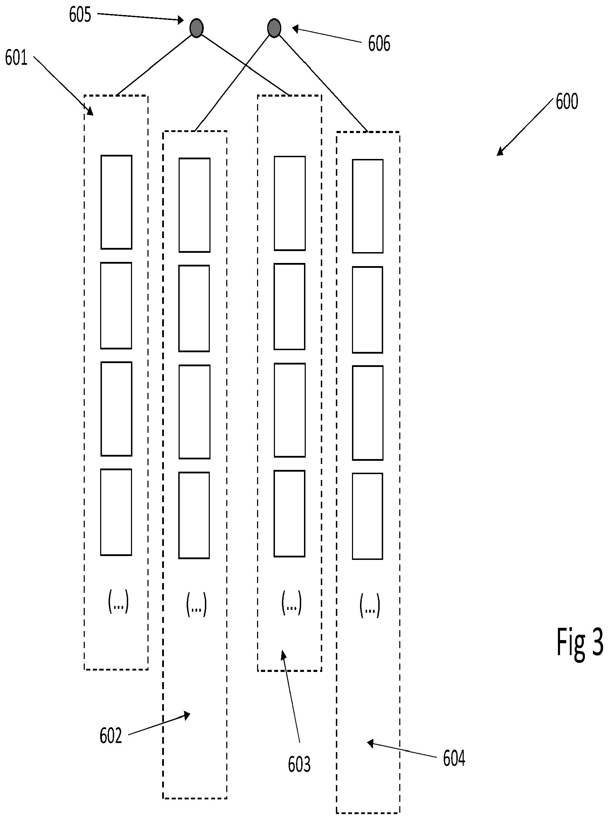

Figure 3 illustrates a semiconductor device 600 according to an embodiment of the present invention. The semiconductor device 600 comprises four regions. The first three regions 601, 602 and 603 are similar to the three regions 511, 512 and 513 described in Figure 2. The fourth region 604 has the same structure as the second region 602. In this exemplary embodiment of the present invention the first region and the third region are connected to a first pin 605, and the second region 602 and the fourth region 604 are connected to a second pin 606.

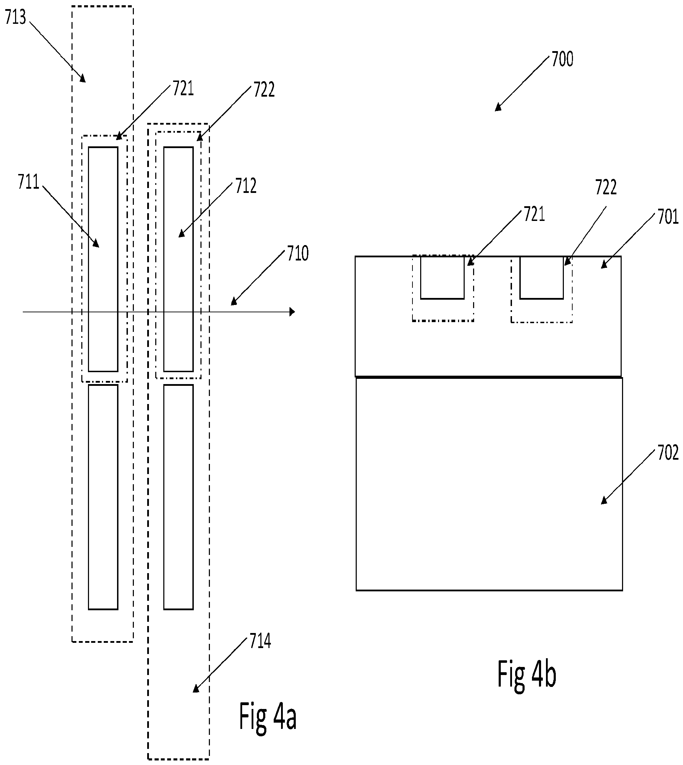

Figures 4a and 4b illustrate a semiconductor device 700 according to an embodiment of the present invention. Figure 4b shows the semiconductor device from Figure 4a with a cut across the line 710. The semiconductor device 700 is similar to the semiconductor devices described in Figures 2 and 3. The first region 713 comprises a first well 721, wherein the polarity of the first well 721 is opposite of the polarity of the first layer 711, and wherein the first well 721 is positioned around the first layer 711. The second region 714 comprises a second well 722, wherein the polarity of the second well is opposite of the polarity of the third layer 712, and wherein the second well 722 is positioned around the third layer 712. The third region can comprise a third well (the third region is not shown in Figures 4a and 4b), wherein the polarity of the third well is opposite of the polarity of the fifth layer, wherein the third well is positioned around the third layer.

According to an embodiment of the invention the length of the first layer 501, the length of the second layer 502, the length of the third layer 503, the length of the fourth layer 504, the length of the fifth layer 505 and the length of the sixth layer 506 can be about the same size.

The first region can comprise of different number of layers, e.g. first eight layers, which first eight layers are of the first type and the second type alternatively. Accordingly the second region can also comprise of second eight layers, which second eight layers are of the second type and the first type alternatively. Finally the third region can comprise of third eight layers, which third eight layers are of the first type and the second type alternatively.

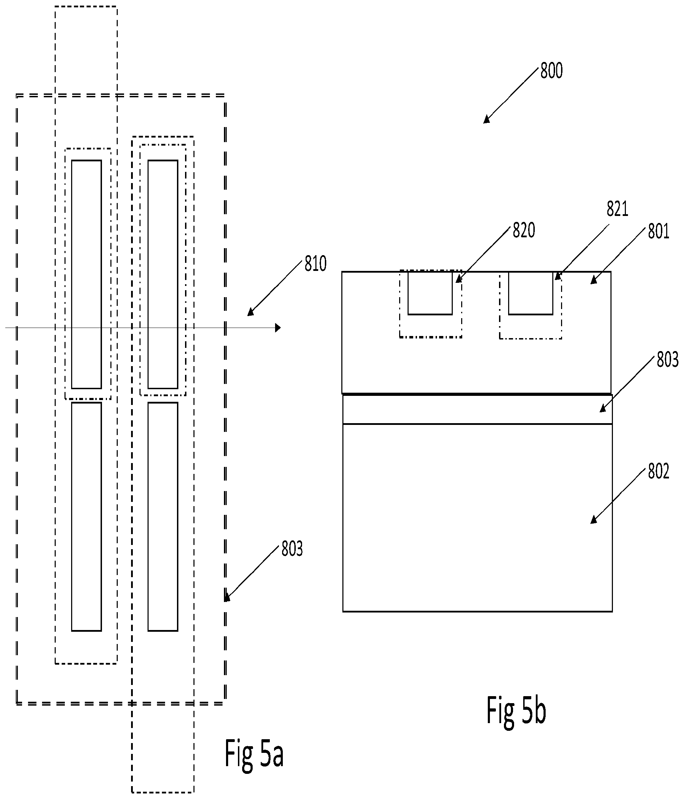

Figures 5a and 5b illustrate a semiconductor device 800 according to an embodiment of the present invention. Figure 5b shows the semiconductor device from Figure 5a with a cut across the line 810. The main structure of this embodiment is similar to the semiconductor device shown in Figures 4a and 4b. The semiconductor device 800 further comprises a doping polarity isolation 801 directly under and around the regions, wherein the doping of the doping polarity isolation is lower than the doping of the wells 820 and 821.

According to an embodiment of the invention the semiconductor device comprises a substrate 802 positioned directly under the doping polarity isolation 801, wherein the doping of the doping polarity isolation 801 is lower than the doping of the substrate 802.

According to an embodiment of the invention the semiconductor device comprises one or more buried layers 803 positioned between the doping polarity isolation 801 and the substrate 802.

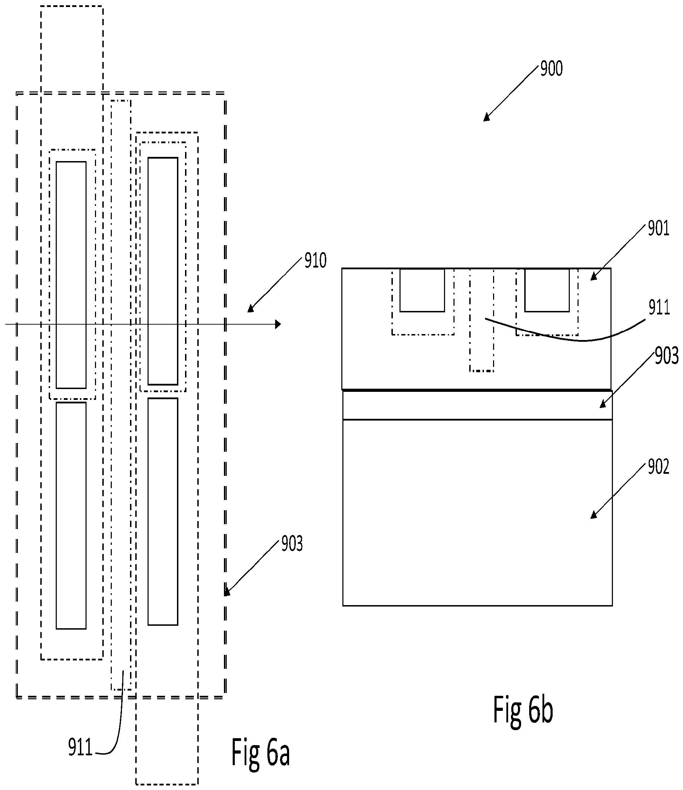

Figures 6a and 6b illustrate a semiconductor device 900 according to an embodiment of the present invention. Figure 6b shows the semiconductor device from Figure 6a with a cut across the line 910. The main structure of this embodiment is similar to the semiconductor device shown in Figures 4a, 4b, 5a and 5b. The semiconductor device 900, next to doping polarity isolation 901, the substrate 902 and buried layer 903, further comprises deep wells 911 between all the regions, which acts as an isolation layer. The buried layer 903 and the deep wells 911 are preferably of the same polarity.

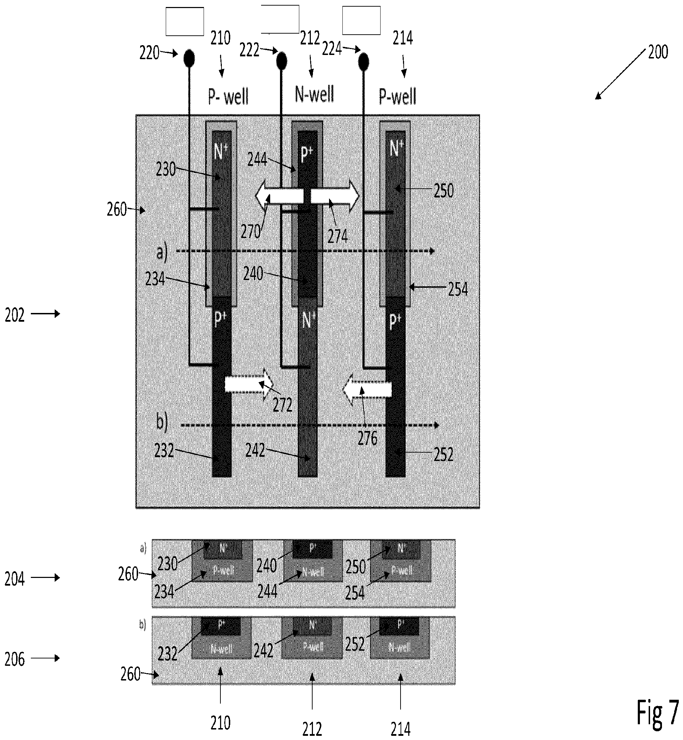

Figure 7 illustrates a semiconductor device 200 according to an embodiment of the present invention.

The semiconductor device 200 is shown in a top view marked with the reference number 202 in Figure 7, a first side view across line a) in Figure 7 marked with the reference number 204 in Figure 7, and a second side view across line b) in Figure 7 marked with the reference number 206 in Figure 7.

The semiconductor device comprises three regions, a first region/a first finger 210, a second region/a second finger 212, and a third region/a third finger 214. These three regions/fingers 210, 212 and 214 are positioned horizontally next to each other, as shown in Figure 7.

The semiconductor device can comprise a P- area 260 wherein these three regions 210, 212 and 214 are positioned.

The first region 210 comprises a first N+ layer 230, a first P+ layer 232 and a first P-well 234 around the first N+ layer 230. The first N+ layer 230 and the first P+ layer 232 are positioned in a continued way (i.e. laterally along the first finger 210), or vertically in respect to each other, as shown in Figure 7. In the exemplary embodiment shown in Figure 7 the first N+ layer 230 and the first P+ layer 232 are about the same length. However, the invention includes all suitable and applicable length ratios between the first N+ layer 230 and the first P+ layer 232 within the first region 210.

The second region 212 comprises a second P+ layer 240, a second N+ layer 242 and a second N-well 244 around the second P+ layer 240. The second P+ layer 240 and the second N+ layer 242 are positioned in a continued way (i.e. laterally along the second finger 212), or vertically in respect to each other, as shown in Figure 7. In the exemplary embodiment shown in Figure 7 the second P+ layer 240 and the second N+ layer 242 are about the same length. However, the invention includes all suitable and applicable length ratios between the second P+ layer 240 and the second N+ layer 242 within the second region 212.

The second region 212 is positioned horizontally across the first region 210, as shown in Figure 7. The second P+ layer 240 and the second N+ layer 242 are positioned horizontally across the first N+ layer 230 and the first P+ layer 232, respectively, as shown in Figure 7.

The third region 214 comprises a third N+ layer 250, a third P+ layer 252 and a third P-well 254 around the third N+ layer 250. The third N+ layer 250 and the third P+ layer 252 are positioned in a continued way (i.e. laterally along the third finger 214), or vertically in respect to each other, as shown in Figure 7. In the exemplary embodiment shown in Figure 7 the third N+ layer 250 and the third P+ layer 242 are about the same length. However, the invention includes all suitable and applicable length ratios between the third N+ layer 250 and the third P+ layer 252 within the third region 214.

The third region 214 is positioned horizontally across the second region 212, as shown in Figure 7. The third N+ layer 250 and the third P+ layer 252 are positioned horizontally across the second P+ layer 240 and the second N+ layer 242, respectively, as shown in Figure 7.

The semiconductor device further comprises three pins, a first pin 220 connected to the first region 210, a second pin 222 connected to the second region 212 and a third pin 224 connected to the third region 214.First and third pin may be electrically connected.

Such positioning of N+ and P+ layers 230, 232, 240, 242, 250 and 252 in the three regions 210, 212 and 214 as shown in Figure 7, secures that a current is flowing in both directions. The current is flowing:
- from the second P+ layer 240 towards the first N+ layer 230, as indicated with a first arrow with the reference sign 270, and
- from the second P+ layer 240 towards the third N+ layer 250, as indicated with a second arrow with the reference sign 274.

The current can alternatively flow:
- from the first P+ layer 232 towards the second N+ layer 242, as indicated with a third arrow with the reference sign 272, and
- from the third P+ layer 252 towards the second N+ layer 242, as indicated with a fourth arrow with the reference sign 276.

Thus, the top part of the layers is active for one polarity and the bottom part of the layers is active for the other polarity. For a positive polarity on pin 1 (reference sign 222) the SCR in the upper part of the semiconductor device will be active and the current can flow in the upper part, the reference signs 270 and 274. For a positive polarity on pin 2 (reference signs 220 and 224) the forward biased diode in the lower part of the semiconductor device will be active and the current can flow in the lower part, the reference signs 272 and 276.

The semiconductor device 200 according to this embodiment of the present invention has a significant advantage that a width of the second N-well 244 can be decreased, which means that the capacitance of the semiconductor device 200 will be decreased. Such a junction capacitance of the semiconductor device 200 will be reduced by at least 15-20%, while the same an ESD robustness of the semiconductor device 200 will be maintained.

This is significant advantage compared to the semiconductor devices known in the art, since the system level ESD protection of the semiconductor device 200 has a lower capacitance so to maintain signal integrity of high speed data lines. Doping layers as described in the embodiments of the present invention allows to reduce the capacitance of the device for at least 15-20%.

For slower pulses such as the 8/20 surge pulse a homogeneous triggering of different SCR fingers, i.e. three regions explained above, becomes important. Which SCR finger triggers first depends on factors which cannot be controlled. Therefore, it must be made sure that the adjacent fingers start to trigger sufficiently quick to so improve the surge robustness. The embodiments of the present invention make the layout of the semiconductor device more symmetric, which helps to avoid problems with adjacent finger triggering.

In an embodiment of the present invention a N-well and a P-well are used, in which N-well and P-well the contact regions are placed, which is an unidirectional SCR. In other embodiment of the present invention two N-wells are used and a punch through stopper in between the two N-wells, which is a bidirectional SCR.

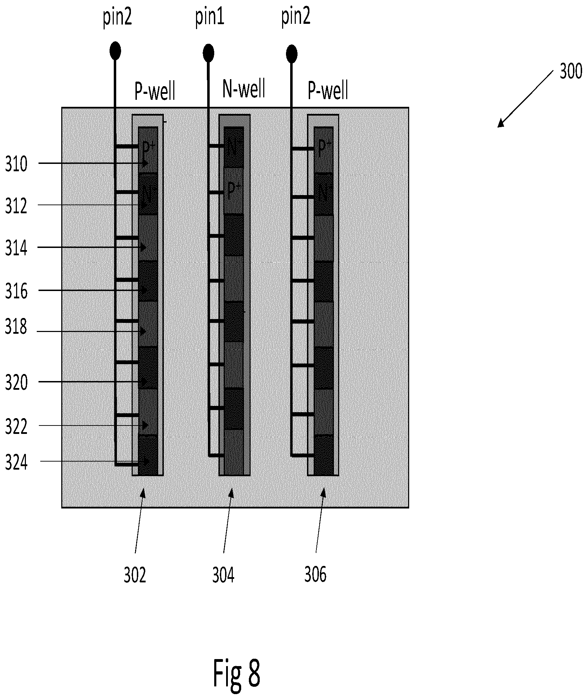

In embodiment of the present invention shown in Figure 8, the three regions 302, 304 and 306 can comprise multiple N+ and P+ alternating layers/regions, i.e. the three regions are divided into many laterally aligned regions/layers/segments.

The first region 302 comprises in this exemplary embodiment a first P+ segment 310, a second N+ segment 312, a third P+ segment 314, a fourth N+ segment 316, a fifth P+ segment 318, a sixth N+ segment 320, a seventh P+ segment 322, and an eighth N+ segment 324.

The second region 304 and the third region 306 have a similar structure as the first region 302, as shown in Figure 8.

In this exemplary embodiment each of the three regions 302, 304 and 306 comprises 8 segments. The present invention covers also any other applicable number of the segments within the three regions 302, 304 and 306.

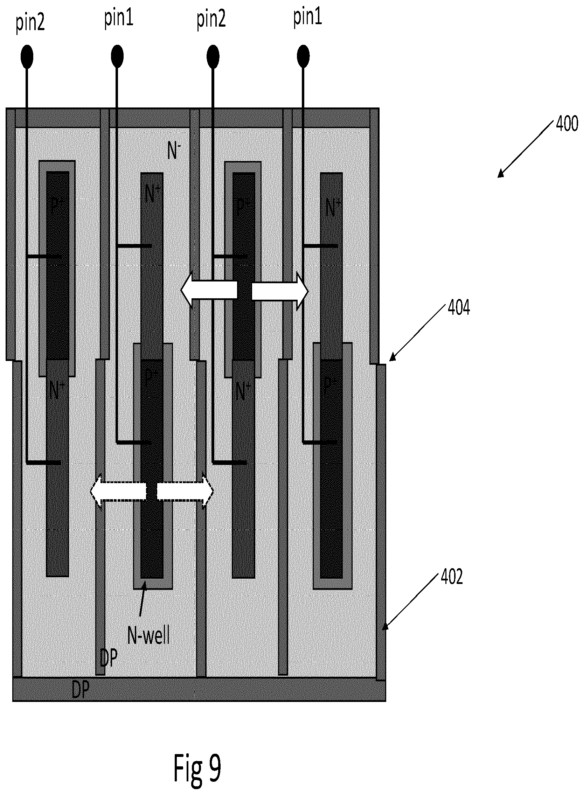

A semiconductor device 400 according to an embodiment of the present invention is shown in Figure 9. The semiconductor device 400 is similar to the semiconductor device 200 as shown in Figure 7.

The semiconductor device 400, as shown in Figure 9, comprises four regions, wherein the semiconductor device further comprises a deep well (DP) isolation 402 around the four regions.

The DP isolation layout 402 can be implemented in stepwise way, as indicated by the reference sign 404 in Figure 9.

However, the implementation of this embodiment depends on the doping polarity of an epitaxial region/substrate. If the epi/substrate polarity would be of a P-type and the DP of N-type, the stepwise layout 404 could be omitted.

Also this embodiment of the present invention secures that the junction capacitance of the semiconductor device 400 is reduced by at least 15-20% while the same ESD robustness of the semiconductor device 400 is maintained.

As shown in the exemplary embodiments of the present invention, it is possible to reduce the area and thereby also the capacitance of the lowly doped junction regions of the semiconductor device. In addition, the layout of the semiconductor service becomes more symmetric and therefore the triggering of adjacent fingers/regions/layers of the semiconductor device is not dependent on the position of the first triggered finger/region/layer.

Such a laterally segmented layout of an SCR, as described in the above embodiments of the present invention, allows to reduce the capacitance of the ESD protection semiconductor device. In addition, it allows that the current spreading between the SCR fingers occurs more homogeneously.

Buried layers can be placed below the structures for improved isolation to the substrate.

The holding voltage of an SCR is relatively high.

Particular and preferred aspects of the invention are set out in the accompanying independent claims. Combinations of features from the dependent and/or independent claims may be combined as appropriate and not merely as set out in the claims.

The scope of the present disclosure includes any novel feature or combination of features disclosed therein either explicitly or implicitly or any generalisation thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

Term "comprising" does not exclude other elements or steps, the term "a" or "an" does not exclude a plurality. Reference signs in the claims shall not be construed as limiting the scope of the claims.

## Claims

1. A semiconductor device comprising:
- at least three regions, a first region, a second region, and a third region,
- wherein the first region comprises a first layer and a second layer, wherein first layer and the second layer are positioned laterally along the first region, wherein the first layer and the second layer have opposite polarity,
- wherein the second region comprises a third layer and a fourth layer, wherein third layer and the fourth layer are positioned laterally along the second region, wherein the third layer and the fourth layer have opposite polarity,
- wherein the third region comprises a fifth layer and a sixth layer, wherein fifth layer and the sixth layer are positioned laterally along the third region, wherein the fifth layer and the sixth layer have opposite polarity.

2. A semiconductor device as claimed in claim 1, wherein the first layer is positioned substantially across the third layer, the third layer is positioned substantially across the fifth layer, the second layer is positioned substantially across the fourth layer and the fourth layer is positioned substantially across the sixth layer.

3. A semiconductor device as claimed in claims 1 or 2, wherein the first layer, the fourth layer and the fifth layer are of a first type, and wherein the second layer, the third layer and the sixth layer are of a second type.

4. A semiconductor device as claimed in claim 3, wherein the first type is a N type, and the second type is a P type.

5. A semiconductor device as claimed in claim 3, wherein the first type is a P type, and the second type is a N type.

6. A semiconductor device as claimed in any of the previous claims, wherein the first region and the third region are connected to a first pin, and wherein the second region is connected to a second pin.

7. A semiconductor device as claimed in any of the previous claims, wherein:
- wherein the first region comprises a first well, wherein the polarity of the first well is opposite of the polarity of the first layer, wherein the first well is positioned around the first layer,
- wherein the second region comprises a second well, wherein the polarity of the second well is opposite of the polarity of the third layer, wherein the second well is positioned around the third layer,
- wherein the third region comprises a third well, wherein the polarity of the third well is opposite of the polarity of the fifth layer, wherein the third well is positioned around the third layer.

8. A semiconductor device as claimed in any of the previous claims, wherein the length of the first layer, the length of the second layer, the length of the third layer, the length of the fourth layer, the length of the fifth layer and the length of the sixth layer are about the same size.

9. A semiconductor device as claimed in any of the previous claims, wherein the first region comprises first N, with N a natural number greater than 2, layers, which first N layers are of the first type and the second type alternatively, the second region comprises second N layers, which second N layers are of the second type and the first type alternatively and the third region comprises third N layers, which third N layers are of the first type and the second type alternatively.

10. A semiconductor device comprising:
- a first region, a second region and a third region positioned next to each other,
- wherein the first region comprises:
∘ a first N+ layer, a first P+ layer and a first P-well around the first N+ layer, wherein the first N+ layer and the first P+ layer are positioned laterally along the first region,
- wherein the second region comprises:
∘ a second P+ layer, a second N+ layer and a second N-well around the second P+ layer, wherein the second P+ layer and the second N+ layer are positioned laterally along the second region,
- wherein the second P+ layer and the second N+ layer are positioned horizontally across the first N+ layer and the first P+ layer, respectively,
- wherein the third region comprises:
∘ a third N+ layer, a third P+ layer and a third P-well around the third N+ layer, wherein the third N+ layer and the third P+ layer are positioned laterally along the third region,
- wherein the third N+ layer and the third P+ layer are positioned horizontally across the second P+ layer and the second N+ layer, respectively.

11. A semiconductor device as claimed in any of the previous claims, wherein the semiconductor device comprises a doping polarity isolation directly under and around the regions, wherein the doping of the doping polarity isolation is lower than the doping of the wells.

12. A semiconductor device as claimed in any of the previous claims, wherein the semiconductor device comprises a substrate positioned directly under the doping polarity isolation, wherein the doping of the doping polarity isolation is lower than the doping of the substrate.

13. A semiconductor device as claimed in any of the previous claims, wherein the semiconductor device comprises a buried layer positioned between the doping polarity isolation and the substrate.

14. A semiconductor device as claimed in any of the previous claims, wherein the semiconductor device comprises deep wells between all the regions.

15. A semiconductor device as claimed in claim 1, wherein the semiconductor device further comprises a fourth region,
- wherein the fourth region comprises a seventh layer and a eight layer, wherein seventh layer and the eighth layer are positioned laterally along the fourth region, wherein the seventh layer and the eighth layer have opposite polarity,
- wherein the fifth layer is positioned substantially across the seventh layer, and the sixth layer is positioned substantially across the eighth layer,
- wherein the first region and the third region are connected to a first pin, and wherein the second region and the fourth region are connected to a second pin.

16. A semiconductor device comprising:
- at least two regions, a first region and a second region,
- wherein the first region comprises a first layer of a first type, and a second layer of a second type, wherein the second type is opposite to the first type, wherein the first layer and the second layer are positioned laterally along the first region,
- wherein the second region comprises a third layer of the second type, and a fourth layer of the first type, wherein the third layer and the fourth layer are positioned laterally along the second region,
- wherein the first layer is positioned substantially across the third layer, and the second layer is positioned substantially across the fourth layer.

17. A method of producing a semiconductor device as claimed in any of the previous claims.
